# EUROPEAN PATENT SPECIFICATION

(11) **EP 0 404 124 B1**
(45) Date of publication and mention of the grant of the patent: **09.10.1996**
(21) Application number: 90111687.1
(22) Date of filing: 20.06.1990
(51) Int. Cl.: H03K 17/06

(54) **Charge pump having pull-up circuit operating with two clock pulse sequences**
Eine Erhöhungsschaltung enthaltende Ladungspumpe, welche mit zwei Taktimpulssequenzen arbeitet
Pompe de charges ayant un circuit de tirage fonctionnant avec deux séquences d'impulsions d'horloge

(30) Priority: 20.06.1989 JP 158587/89
(43) Date of publication of application: 27.12.1990
(73) Proprietor: NEC CORPORATION, Tokyo (JP)
(72) Inventor: Kobatake, Hiroyuki, c/o NEC Corparation, Tokyo (JP)
(74) Representative: Resch, Michael, Dipl.-Phys.

(56) References cited:
- WO-A-84/01659
- WO-A-86/06539
- ELECTRONIC DESIGN, vol. 31, no. 17, 18 August 1983, Hasbrouck Heights, New Jersey, pp. 189-196; JONES ET AL.: 'EEPROM adapts easily to in-system changes'

## Description

### BACKGROUND OF THE INVENTION

The present invention relates to semiconductor circuits, and more specifically to a charge pump which is used in integrated circuits.

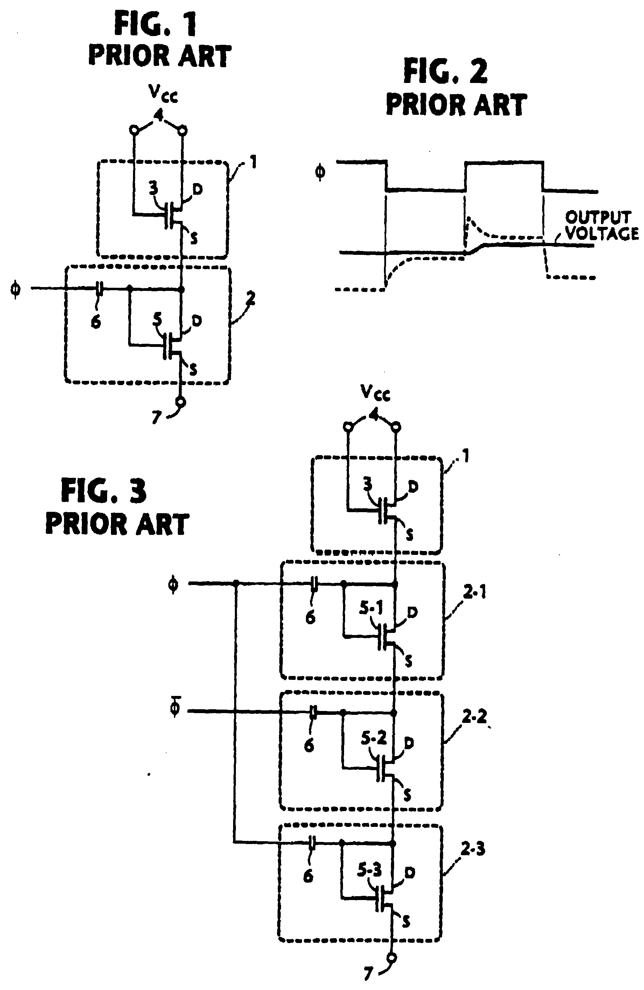

As shown in Fig. 1, a prior art charge pump comprises a charge-up circuit 1 and a pull-up circuit 2. Charge-up circuit 1 is formed by an N-channel enhancement mode MOSFET (field effect transistor) 1 whose drain and gate are coupled to a voltage supply 4 at voltage V_{CC} and whose source is coupled to the drain and gate of an N-channel enhancement mode MOSFET 5 of pull-up circuit 2 and thence to a clock source φ through a capacitor 6. The source of MOSFET 5 is coupled to an output terminal 7 which is in turn connected to a suitable utilization circuit. When clock sequence φ switches to low level, the drain of MOSFET 5 is driven by MOSFET 3 and its potential increases as indicated by a dotted line in Fig. 2 to a level V_{CC} - V_{Te} (where V_{Te} is the threshold of MOSFET 3). On reaching this level, MOSFET 3 Is turned off. When clock sequence goes high, the voltage at the drain of MOSFET 5 rises sharply to a level V_{CC} - V_{Te} + V_{φ} (where V_{φ} is the voltage of the clock sequence) by the action of capacitor 6. This voltage is applied through MOSFET 5 to output terminal 7, producing an output voltage (V_{CC} - V_{Te}) + (V_{φ} - V_{Te}) which it indicated by a solid line curve in Fig. 2. To obtain a higher output voltage, pull-up circuits 2- 1, 2-2 and 2-3 are cascaded as shown in Fig. 3 such that the second stage is supplied with clock sequence of opposite phase to those of clock sequences supplied to the odd-numbered stages. The voltage at the drain of MOSFET 5-2 is driven to a level equal to (V_{CC} - V_{Te}) + (Vφ - V_{Te}) when the opposite phase clock is at low level. When the opposite-phase clock goes high, the drain of MOSFET 5-2 Is driven to a level equal to (V_{CC} - V_{Te}) + (Vφ - V_{Te}) + V_{φ} which is applied through MOSFET 5-2 to the drain of MOSFET 5-3, which, as a result rises to a level (V_{CC} - V_{Te}) + (Vφ - V_{Te}) + (Vφ - V_{Te}). The output voltage of this multi-stage circuit Is equal to (V_{CC} - V_{Te}) + N(V_{φ} - V_{Te}), where N represents the number of cascaded pull-up circuits 2. Usually V_{φ} is set equal to V_{CC}, and the output voltage is 2V_{CC} - 2V_{Te}. Since the threshold voltage V_{Te} is of a substantial value in comparison with V_{CC} the output voltage is too low for some applications. If source voltage V_{CC} is equal to or lower than the threshold voltage V_{Te}, the charge-up circuit becomes Inoperative, and if V_{φ} ≤ V_{Te} the pull-up circuit becomes inoperative. In either case, the charge pump is inoperative. In addition, a large number of pull-up circuits would be required. For example, if V_{CC} - V_{φ} - 1.5 volts, V_{Te} = 1.0 volt, twenty-nine pull-up circuits are required to obtain an output voltage of 15 volts.

WO-84/01659 discloses a charge pump wherein a first capacitive node controls a transistor to pass a charging voltage from an input line to charge a second capacitive node which is coupled to the first capacitive node by a transistor. Two out-of-phase clock pulses coupled to respective capacitors provide a charge pumping effect to raise the potential on the first capacitive node to a level such that a transistor coupled thereto passes the voltage on the input line to the output line without threshold losses. WO-84/01659 does not refer to the problem of how to obtain a charge pump for generating a high output voltage without requiring a reduced number of pull-up circuits.

### SUMMARY OF THE INVENTION

It is therefore an object of the present invention to provide a charge pump capable of generating a high output voltages which does not require a large number of pull-up circuit.

The invention is defined in claim 1. Further embodiments are defined in the sub-claims. In particular, the invention also provides a charge pump comprising at least one further pull-up circuit, as defined in claim 6.

### BRIEF DESCRIPTION OF THE DRAWINGS

The present invention will be described in further detail with reference to the accompanying drawings, in which:
Fig. 1 is a circuit diagram of a prior art charge pump;
Fig. 2 is a waveform diagram associated with the prior art charge pump;
fig. 3 is a circuit diagram of a prior art multi-stage charge pump;
Fig. 4 is a circuit diagram of a charge pump according to an embodiment of the present invention;
Fig. 5 is a waveform diagram associated with the embodiment of this invention;
Fig. 6 is a circuit diagram of a multi-stage charge pump of this invention; and
Fig. 7 is a circuit diagram of a modification of this invention

### DETAILED DESCRIPTION

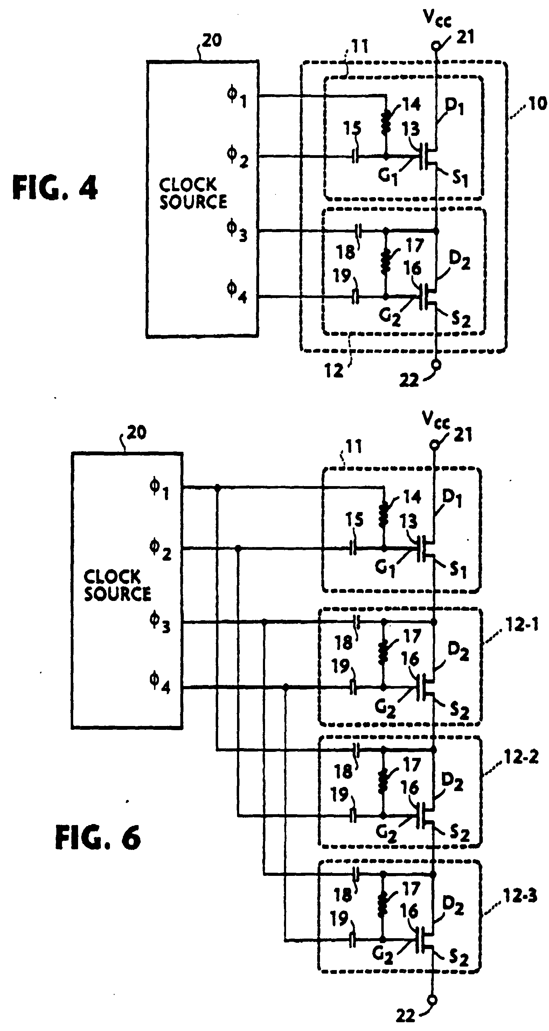

Referring now to Fig. 4, there is shown a charge pump according to an embodiment of the present invention. The charge pump shown at 10 comprises a charge-up circuit 11 and a pull-up circuit 12. Charge-up circuit 11 comprises an N-channel enhancement mode MOSFET 13 having a gate G₁ coupled through a resistor 14 to a clock source 20 to receive a fist clock pulse sequence φ₁ and through a capacitor 15 to receive a second clock sequence φ₂. MOSFET 13 has its drain D₁ connected to a voltage supply 21 to receive source voltage V_{CC} and its source S₁ coupled to the drain D₂ of an N-channel enhancement mode MOSFET 16 of charge-up circuit 12. MOSFET 16 has its gate G₂ and drain D₂ coupled together by a resistor 17, with the drain D₂ being further coupled through a capacitor 18 to clock source 20 to receive a third clock sequence φ₃ and the Gate G₂ being further coupled through a capacitor 19 to the clock source to receive a fourth clock sequence φ₄.

Resistor 14 and capacitor 15 form a series circuit across terminals φ₁ and φ₂ of clock source 20 with a time constant value R₁·C₁ (where R₁ and C₁ are the resistance and capacitance values of resistor 14 and capacitor 15, respectively). Likewise, resistor 17 and capacitor 19 present a series circuit between drain D₂ of MOSFET 16 and clock terminal φ₄ with a time constant value C₂·R₂ (where C₂ is the capacitance of capacitor 19 and R₂ is the resistance of resistor 17). The source S₂ of MOSFET 16 is coupled to the output terminal 22 of the charge pump 10 to which a utilization circuit is connected.

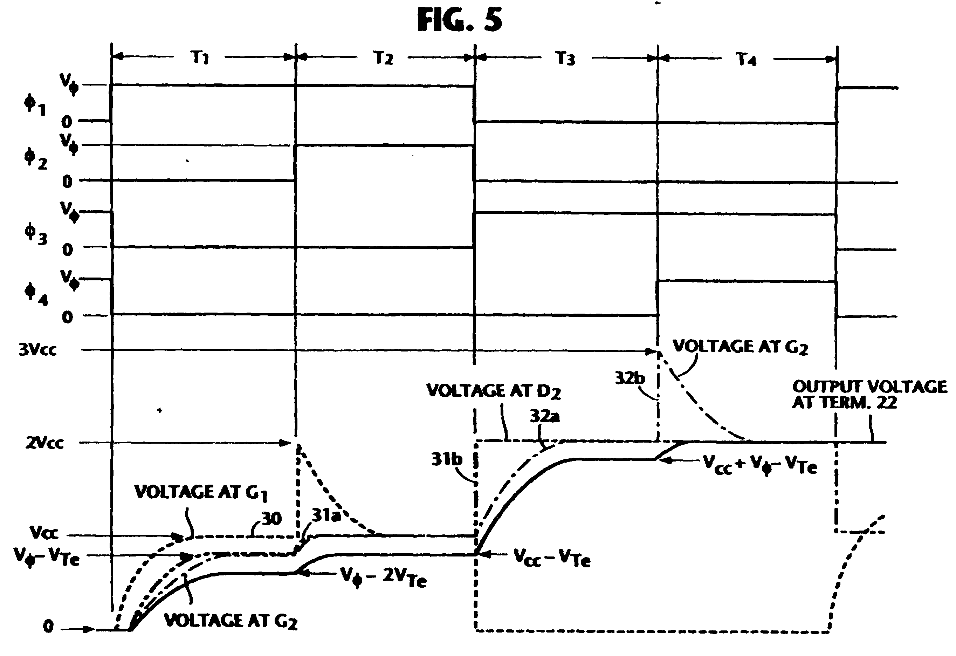

The first to fourth clock sequences have the waveforms as shown in Fig. 5. The first and third clock sequences φ₁ and φ₃ are of opposite polarity of the same clock period which is twice the period of clock sequences φ₂ and φ₄ so that these clock sequences produce a unique combination of four different voltage levels respectively for periods T₁, T₂, T₃ and T₄. Specifically, during period T₁, clock sequence is at high voltage V_{φ} and all other clock sequences are at zero voltage. During period T₂, clock sequences φ₁ and φ₂ are at voltage V_{φ} and other sequences are at zero voltage. During period T₃, only clock sequence φ₃ is at high level, and during the last period T₄, φ₃ and φ₄ are at high level. Note that the time constant value C₁·R₁ is much smaller than period T₁ or T₂ and the time constant value C₂·R₂ is much smaller than period T₃ or T₄.

Assume that the voltage V_{φ} is equal to source voltage V_{CC}. During period T₁, a voltage difference V_{φ} develops across terminals φ₁ and φ₂ and capacitor 15 is charged through resistor 14, generating a potential which rises exponentially at the gate C₁ of MOSFET 13, following a curve V_{φ} (1 - e^{-t}/C₁ . R₁) as indicated by a dotted line 30 in Fig. 5. Since T₁ is much greater than time constant C₁·R₁, the voltage at gate C₁ will eventually reach V_{φ} (= V_{CC}) within period T₁. During period T₂, clock terminal φ₂ is driven to the same potential as at terminal φ₁, This voltage adds up to the voltage developed across capacitor 15, presenting a voltage 2V_{φ} to gate C₁. This voltage decays exponentially following a curve V_{φ}(1 + e^{-t}/C₁·R₁) to the V_{φ} level within period T₂ as illustrated. At the instant the voltage at gate C₁ rises to the level 2V_{CC}, the voltage at the drain D₂ of MOSFET 16 is driven to V_{CC} as shown at 31 a if V_{CC} is equal to or lower than 2V_{φ} - V_{Te} (where V_{Te} is the threshold voltage of enhancement mode MOSFET 13), or driven to 2V_{φ}, - V_{Te} if V_{CC} is higher than 2V_{φ} - V_{Te}.

During period T₃ in which the third clock sequence φ₃ is the only one that is driven to high level, the voltage V_{φ} of this clock sequence is supplied through capacitor 18 to the drain D₂ of MOSFET 16, so that the voltage at drain D₂ sharply rises to a level 2V_{φ} (= 2V_{CC}) as shown at 31b in Fig. 5, and capacitor 19 is charged through resistor 17. Since the time constant C₂·R₂ is smaller than T₃, the voltage at the gate G₂ of MOSFET 16 rises exponentially as shown at 32a to the same level as at the drain D₂ of MOSFET 16 within period T₃.

During the successive periods T₁ through T₃, the voltage at the output terminal 22 increases exponentially in a stepwise manner. Specifically, it exponentially increases to a level V_{φ}- 2V_{Te} during T₁, rises to a level V_{CC} - V_{Te} during T₂, and jumps to a level V_{CC} + V_{φ} - V_{Te} during T₃.

During the next period T₄ In which the third and fourth clock sequences are at high level, the voltage at the gate G₂ of MOSFET 16 rapidly rises as shown at 32b to a level which is three times as high as the source voltage V_{CC}. This voltage level is equal to the potential at the drain D₂ plus 2V_{φ}. Since the time constant C₂·R₂ is much smaller than period T₄, the voltage at gate G₂ decays exponentially to the same voltage level as at the drain D₂ during period T₄. During period T₄, the voltage at the output terminal 22 further increases to the level 2V_{CC}.

When the potential at gate G₂ increased to 3V_{CC}, the voltage V_{OUT} at the output terminal 22 increases from the level (V_{CC} + V_{φ} - V_{Te}) to 2V_{CC} (= voltage at drain D₂ + V_{φ}) if V_{φ} is equal to or higher than V_{Te}, or increases to a level equal to the voltage at drain D₂ + 2V_{φ} - V_{To} if V_{φ} is lower than V_{Te}.

It is seen that the voltage obtained by the use of a single pull-up circuit of this invention is equal to V_{φ} if V_{φ} ≥ V_{Te} or 2V_{φ} - V_{Te} if V_{φ} < V_{Te}.

It is seen from the foregoing that as long as a relation V_{φ} > V_{Te}/2 holds both charge-up and pull-up circuits operate satisfactorily. Since the voltage V_{φ} of the clock sequences for MOS integrated circuitry is usually equal to the source voltage V_{CC}, the charge pump of this invention can operate satisfactorily even when the source voltage is at very low level. For example, if V_{Te} is 1.0 volt the charge pump will operate at a source voltage of 0.5 volts.

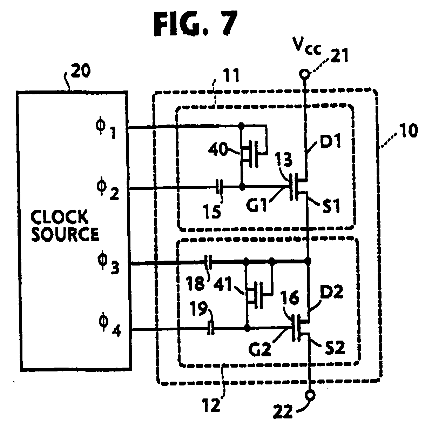

A higher output voltage can be obtained by cascading pull-up circuits 12.1, 12-2 and 12.3 as shown in Fig. 6 such that the phases of clock sequences supplied to the even-numbered stage 12-2 are opposite to the phases of clock sequences supplied to the odd. numbered pull-up circuits 12.1, 12-3. Since the voltage at the drain D₂ of each pull-up circuit is either V_{φ} or 2V_{φ} - V_{Te}, the output voltage V_{OUT} is equal to the voltage at drain D₂ plus NV_{φ} if V_{φ} is equal to or higher than V_{Te} or equal to the voltage at drain D₂ plus N(2V_{φ} - V_{Te}) if V_{φ} is lower than V_{Te} (where N is the number of cascaded pull-up circuits).

Therefore, the number of pull-up circuits necessary for a given application can be reduced In comparison with the prior art charge pump. For example, if V_{CC} = V_{φ} = 1.5 volts and V_{Te} = 1.0 volt nine pull-up circuits will be sufficient to obtain an output voltage of 15 volts.

To reduce the amount of space for implementing the charge pump, resistors 14 and 17 are preferably replaced with N-channel depletion mode MOSFETs 40 and 41, respectively, as shown in Fig. 7. Each of these MOSFETs has Its gate and drain electrodes coupled together to form an equivalent resistance element. Alternativeiy the gate and source electrodes, may be coupled together to form a resistor.

## Claims

1. A charge pump comprising:
a charge-up circuit (11) connected to a voltage source (21);
clock generator means (20) for generating third and fourth clock pulse sequences (Φ₃, Φ₄) respectively at third and fourth output terminals of the clock generator means (20);
a pull-up circuit (12; 12-1) including a first field-effect transistor (16) having a drain-source path connected between said charge-up circuit (11) and an output terminal (22) of the charge pump, and a gate electrode, and
a first time constant circuit having first (18) and second (19) capacitive elements and a resistive element (17; 41) connected therebetween, said first time constant circuit being connected across said third and fourth output terminals of said clock generator means (20) for successively applying voltages to one end of the drain-source path and to the gate electrode of said transistor (16) in response to said third and fourth clock pulse sequences (Φ₃, Φ₄),
**characterized in that**
the clock generator means (20) further generates first and second clock pulse sequences (Φ₁, Φ₂) respectively at first and second output terminals of said clock generator means (20) and successively applies said first and second clock pulse sequences (Φ₁, Φ₂) to said charge-up circuit (11),
the first and third clock sequences (Φ₁, Φ₃) are of opposite polarity and the second clock sequence (Φ₂) is generated after the beginning of the first pulse clock sequence (Φ₁) and before the beginning of the third clock sequence (Φ₃) and the fourth clock seqence (Φ₄) is generated after the beginning of the third clock sequence (Φ₃),
said charge-up circuit (11) comprises a second field-effect transistor (13) having its source-drain path connected between said voltage source (21), and said pull-up circuit (12, 12-1) and a second time constant circuit having a capadtive element (15) and a resistive element (14; 40) connected across said first and second output terminals of said clock generator means (20) for successively applying voltages to one end of the drain-source path and to the gate electrode of said second field-effect transistor in response to said first and second clock pulse sequences (Φ₁, Φ₂).

2. A charge pump according to claim 1, characterized in that said first (16) and second (13) field-effect transistors are enhancement mode field-effect transistors.

3. A charge pump as claimed in one of claims 1 or 2,
characterized in that said first clock pulse sequence (Φ₁) has a pulse duration greater than a pulse duration of said second clock pulse sequence (Φ₂) and said third clock pulse sequence (Φ₃) has a pulse duration greater than a pulse duration of said fourth clock pulse sequence (Φ₄).

4. A charge pump as claimed in one of the claims 1 to 3,
characterized in that the resistive element of each of said first and second time constant circuits comprises a third field-effect transistor (40, 41) having a gate electrode and a drain-source path connected at one end to the gate electrode of the third field-effect transistor (40, 41).

5. A charge pump according to claim 4, characterized in that said third field-effect transistor is a depletion-mode field-effect transistor.

6. A charge pump as claimed in one of the claims 1 to 5,
characterized in that it comprises at least one further pull-up circuit (12-2, 12-3), the field-effect transistor (16) of each further pull-up circuit (12-2, 12-3) having its drain-source path connected between the source electrode of the field-effect transistor (16) of the pull-up circuit (12-1) and said output terminal (22) of the charge pump, and the second time constant circuit of each successively disposed further pull-up circuit (12-2, 12-3) being connected across that pair of said first and second or third and fourth output terminals of said dock generator means (20) which is not connected with the second time constant circuit of the previously disposed pull-up circuit (12-1, 12-2).

## Patentansprüche

1. Ladungspumpe, die die folgenden Merkmale aufweist:
einen Aufladeschaltkreis (11), der mit einer Spannungsquelle (21) verbunden ist;
eine Taktgeneratoreinrichtung (20) zum Erzeugen einer dritten und einer vierten Taktpulssequenz (φ₃, φ₄) jeweils an einem dritten und einem vierten Ausgangsanschluß der Taktgeneratoreinrichtung (20);
einen Erhöhungs- bzw. Pull-Up-Schaltkreis (12; 12-1) der folgendes beinhaltet:
einen ersten Feldeffekttransistor (16), dessen Drain-Source-Pfad zwischen den Aufladeschaltkreis (11) und einen Ausgangsanschluß (22) der Ladungspumpe geschaltet ist und der eine Gate-Elektrode aufweist, und
einen ersten Zeitkonstantenschaltkreis, der ein erstes (18) und ein zweites (19) kapazitives Element sowie ein Widerstandselement (17; 41) aufweist, das zwischen diese geschaltet ist, wobei der erste Zeitkonstantenschaltkreis parallel zum dritten und vierten Ausgangsanschluß der Taktgeneratoreinrichtung (20) geschaltet ist, um aufeinanderfolgend Spannungen an ein Ende des Drain-SourcePfades und an die Gate-Elektrode des Transistors (16) anzulegen, und zwar als Antwort auf die dritte und die vierte Taktpulssequenz (φ₃, φ₄),
dadurch gekennzeichnet, daß
die Taktgeneratoreinrichtung (20) weiterhin an einem ersten bzw. an einem zweiten Ausgangsanschluß der Taktgeneratoreinrichtung (20) eine erste bzw. eine zweite Taktpulssequenz (φ₁, φ₂) erzeugt und dem Aufladeschaltkreis (11) aufeinanderfolgend eine erste und eine zweite Taktpulssequenz (φ₁, φ₂) zuführt,
daß die erste und die dritte Taktsequenz (φ₁, φ₃) eine entgegengesetzte Polarität haben und daß die zweite Taktsequenz (φ₂) nach dem Beginn der ersten Pulstaktsequenz (φ₁) und vor dem Beginn der dritten Taktsequenz (φ₃) erzeugt wird, und daß die vierte Taktsequenz (φ₄) nach dem Beginn der dritten Taktsequenz (φ₃) erzeugt wird,
daß der Aufladeschaltkreis (11) einen zweiten Feldeffekttransistor (13) aufweist, dessen Source-Drain-Pfad zwischen die Spannungsquelle (21) und den Pull-Up-Schaltkreis (12, 12-1) geschaltet ist, und daß der Aufladeschaltkreis (11) einen zweiten Zeitkonstantenschaltkreis aufweist, der ein kapazitives Element (15) und ein Widerstandselement (14; 40) aufweist, die parallel zum ersten und zweiten Ausgangsanschluß der Taktgeneratoreinrichtung (20) geschaltet sind, um aufeinanderfolgend einem Ende des Drain-Source-Pfades und der Gate-Elektrode des zweiten Feldeffekttransistors Spannungen zuzuführen, und zwar als Antwort auf die erste und die zweite Taktpulssequenz (φ₁, φ₂).

2. Ladungspumpe gemäß Anspruch 1, dadurch gekennzeichnet, daß der erste (16) und der zweite (13) Feldeffekttransistor Anreicherungs-Feldeffekttransistoren sind.

3. Ladungspumpe gemäß Anspruch 1 oder 2, dadurch gekennzeichnet, daß die erste Taktpulssequenz (φ₁) eine Pulsdauer hat, die größer als eine Pulsdauer der zweiten Taktpulssequenz (φ₂) ist, und daß die dritte Taktpulssequenz (φ₃) eine Pulsdauer hat, die größer als eine Pulsdauer der vierten Taktpulssequenz (φ₄) ist.

4. Ladungspumpe gemäß einem der Ansprüche 1 bis 3, dadurch gekennzeichnet, daß das Widerstandselement eines jeden des ersten und zweiten Zeitkonstantenschaltkreises einen dritten Feldeffekttransistor (40, 41) aufweist, der eine Gate-Elektrode und einen Drain-Source-Pfad aufweist, der an einem Ende mit der Gate-Elektrode des dritten Feldeffekttransistors (40, 41) verbunden ist.

5. Ladungspumpe gemäß Anspruch 4, dadurch gekennzeichnet, daß der dritte Feldeffekttransistor ein Verarmungs-Feldeffekttransistor ist.

6. Ladungspumpe gemäß einem der Ansprüche 1 bis 5, dadurch gekennzeichnet, daß sie wenigstens einen weiteren Pull-Up-Schaltkreis (12-2, 12-3) aufweist, wobei der Feldeffekttransistor (16) eines jeden weiteren Pull-Up-Schaltkreises (12-2, 12-3) einen Drain-Source-Pfad aufweist, der zwischen die Source-Elektrode des Feldeffekttransistors (16) des Pull-Up-Schaltkreises (12-1) und den Ausgangsanschluß (22) der Ladungspumpe geschaltet ist, und daß der zweite Zeitkonstantenschaltkreis eines jeden weiteren, hintereinander angeordneten Pull-Up-Schaltkreises (12-2, 12-3) parallel zu demjenigen Paar erster und zweiter oder dritter und vierter Ausgangsanschlüsse der Taktgeneratoreinrichtung (20) geschaltet ist, das nicht mit dem zweiten Zeitkonstantenschaltkreis des vorhergehend angeordneten Pull-Up-Schaltkreises (12-1, 12-2) verbunden ist.

## Revendications

1. Pompe de charge comprenant :
un circuit de charge (11) connecté à une source de tension (21) ;
des moyens de générateur d'horloge (20) pour générer des troisième et quatrième séquences d'impulsions d'horloge (φ₃, φ₄) respectivement au niveau de troisième et quatrième bornes de sortie des moyens de générateur d'horloge (20) ;
un circuit d'excursion vers le haut (12 ; 12-1) incluant :
un premier transistor à effet de champ (16) comportant une voie drain-source connectée entre ledit circuit de charge (11) et une borne de sortie (22) de la pompe de charge, et une électrode de grille ; et
un premier circuit de constante de temps comportant des premier (18) et second (19) éléments capacitifs et un élément résistif (17 ; 41) connecté entre, ledit premier circuit de constante de temps étant connecté entre lesdites troisième et quatrième bornes de sortie desdits moyens de générateur d'horloge (20) pour appliquer successivement des tensions sur une extrémité de la voie drain-source et sur l'électrode de grille dudit transistor (16) en réponse auxdites troisième et quatrième séquences d'impulsions d 'horloge *(φ*₃*,* φ₄),
caractérisée en ce que :
les moyens de générateur horloge (20) génèrent en outre des première et seconde séquences d'impulsions d'horloge (φ₁, φ₂) respectivement au niveau de première et seconde bornes de sortie desdits moyens de générateur d'horloge (20) et appliquent successivement lesdites première et seconde séquences d'impulsions d'horloge (φ₁, φ₂) audit circuit de charge (11) ;
les première et troisième séquences d'impulsions d'horloge (φ₁, φ₃) sont de polarités opposées et la seconde séquence d'impulsions d'horloge (φ₂) est générée après le début de la première séquence d'impulsions d'horloge (φ₁) et avant le début de la troisième séquence d'impulsions d'horloge (φ₃) et la quatrième séquence d'impulsions d'horloge (φ₄) est générée après le début de la troisième séquence d'impulsions d'horloge (φ₃) ;
ledit circuit de charge (11) comprend un second transistor à effet de champ (13) qui a sa voie sourcedrain connectée entre ladite source de tension (21) et ledit circuit d'excursion vers le haut (12, 12-1) et un second circuit de constante de temps comportant un élément capacitif (15) et un élément résistif (14 ; 40) connectés entre lesdites première et seconde bornes de sortie desdits moyens de générateur d'horloge (20) pour appliquer successivement des tensions sur une extrémité de la voie drain-source et sur l'électrode de grille dudit second transistor à effet de champ en réponse auxdites première et seconde séquences d'impulsions horloge (φ₁, φ₂).

2. Pompe de charge selon la revendication 1, caractérisée en ce que lesdits premier (16) et second (13) transistors à effet de champ sont des transistors à effet de champ du mode enrichissement.

3. Pompe de charge selon l'une quelconque des revendications 1 et 2, caractérisée en ce que ladite première séquence d'impulsions horloge (φ₁) présente une durée d'impulsion supérieure à une durée d'impulsion de ladite seconde séquence d'impulsions d'horloge (φ₂) et ladite troisième séquence d'impulsions d'horloge (φ₃) présente une durée d'impulsion supérieure à une durée d'impulsion de ladite quatrième séquence d'impulsions d'horloge (φ₄).

4. Pompe de charge selon l'une quelconque des revendications 1 à 3, caractérisée en ce que l'élément résistif de chacun desdits premier et second circuits de constante de temps comprend un troisième transistor à effet de champ (40, 41) comportant une électrode de grille et une voie drain-source connectée au niveau d'une extrémité à l'électrode de grille du troisième transistor à effet de champ (40, 41).

5. Pompe de charge selon la revendication 4, caractérisée en ce que ledit troisième transistor à effet de champ est un transistor à effet de champ du mode appauvrissement.

6. Pompe de charge selon l'une quelconque des revendications 1 à 5, caractérisée en ce qu'elle comprend au moins un circuit d'excursion vers le haut supplémentaire (12-2, 12-3), le transistor à effet de champ (16) de chaque circuit d'excursion vers le haut supplémentaire (12-2, 12-3) ayant sa voie drain-source connectée entre l'électrode de source du transistor à effet de champ (16) du circuit d'excursion vers le haut (12-1) et ladite borne de sortie (22) de la pompe de charge, et le second circuit de constante de temps de chaque circuit d'excursion vers le haut supplémentaire disposé successivement (12-2, 12-3) étant connecté entre la paire desdites première et seconde ou troisième et quatrième bornes de sortie desdits moyens de générateur d'horloge (20) qui n'est pas connectée au second circuit de constante de temps du circuit d'excursion vers le haut disposé précédemment (12-1, 12-2).
